# EUROPEAN PATENT APPLICATION

(11) **EP 1 462 962 A1**
(43) Date of publication of application: **29.09.2004**
(21) Application number: 02795299.3
(22) Date of filing: 29.11.2002
(51) Int. Cl.: G06F 17/50, G06F 9/455

(54) **METHOD AND CIRCUITRY FOR THE FUNCTIONAL TESTING AND ANALYSIS OF LARGE DIGITAL CIRCUITS USING HARDWARE EMULATORS**

(30) Priority: 29.11.2001 ES 200102683
(71) Applicant: Universidad de Sevilla, 41013 Sevilla (ES)
(72) Inventor: Aguirre Echanove, Miguel A. Dpto. Tecno. Elec., 41092 Sevilla (ES); Tombs, Jonathan Dpto. Tecn. Elec., 41092 Sevilla (ES); Torralba Silgado, Antonio Dpto. Tecno. Elec., 41092 Sevilla (ES); Garcia Franquelo, Leopoldo Dpto. Tecno. Elec., 41092 Sevilla (ES)
(74) Representative: Temino Ceniceros, Ignacio
(86) International application number: PCT/ES2002/000571
(87) International publication number: WO 2003/046773

(57) **Abstract**

The invention relates to a method and circuitry for the functional testing and analysis of large digital circuits using hardware emulators. The inventive method is based on an indefinite number of events or conditions (1), (1')... (1). According to the invention, the respective detector circuits (2), (2')... (2) interact with an edge detector (3) which receives information from the external reactivation pad (4). An external system control pad (5) can be used to: monitor both deterministic and time events; more specifically, monitor a deterministic condition and a time condition in run time; generate a signal or flag which registers the event, regardless of its nature; freeze the circuit in order to facilitate the analysis thereof using a graphic system or similar; communicate to the system that an event has occurred and identify which of the programmed events has occurred.

## Description

### OBJECT OF THE INVENTION

This invention refers to a completely automated system for the functional verification of large digital circuits. It is based on three original processes: First a generic digital circuit for the elaboration of functional tests using integrated circuits based on programmable logic and orientated to the development of large integrated digital circuits that provide the possibility of automating the process of debugging. In second place the description of the tasks required for the development of a functional emulation system to realise the necessary debugging functions, and in third place a modification to the traditional methods for the development and debugging of digital systems.

The invention is applicable to the area of large digital circuits and permits the completely generic and automatic insertion of test and debugging inspection into prototype digital circuits.

### ANTECEDENTS OF THE INVENTION

The current techniques, in the area of the analysis and functional test of digital circuits are based on "ad hoc" systems, in those that the tests are carried out by means of creating a specific prototype systems based on programmable logic integrated circuits for each test.

To be more precise, the traditional design flow of digital integrated circuit design uses software programs for all the tasks of functional verification that are carry out though software simulations. These simulations require two elements: a circuit model and the necessary input stimuli for the exhaustive verification of the circuit. At the present time the traditional techniques of debugging begin to become insufficient, fundamentally due to two reasons:
- In the first place the functionality of new devices is so complex that the simulation by means of software requires very long processing times and in most of the cases is impracticable to complete all possible scenarios.
- In second place the elaboration of the input simulation stimuli is a task that presents enormous difficulties. It is necessary to represent a significant quantity of the real life input situations of the final circuit and this is often impracticable.

The techniques of rapid prototyping by means of emulation are now of great importance, they function with a hardware model based on integrated circuit with programmable logic that are inserted in the final system with only slight modifications.

The current techniques based on literature have the limitation that they are associated with each application and actually there is no procedure or means that permits the outlining of a single testing scheme for all situations.

In the field of the available means for the hardware emulation in rapid prototyping, the base is the use of advanced programmable logic devices of the type FPGA-SRAM. The devices currently available in the market provide the following capabilities:
- Capacity to be programmed as many times as is necessary.
- Capacity to read the configuration and state of a running system.
- Capacity to stop the system clock in an appropriate and controlled manner.
- Sufficiently high processing capabilities in order to be able to emulate a given design in the actual conditions of the design.

These are the requirements or capabilities necessary in order to use the technique described in this invention, as will be described below.

From the methodological point of view of the current practice, after the generation of the high level description of the circuit and basic test and simulation, it is possible to build an emulated prototype of the system. With this prototype it is possible to produce real-time or in the worst case, near real-time situations, all depending on the limitations and capabilities of the emulation circuit. Using this system it is currently possible to verify the final system and its global functionality.

### DESCRIPTION OF THE INVENTION

Within the design object of test, a circuit watches over determined events and times simultaneously. The user can decide which signals to be associated with an event though the insertion of a comparator (detection of combinational events) to signal the existence of the event. The user can associate timers (detection of time events) to each event that regulate the activity of the event. Each event has an associated state machine that permits the deactivation of the active event though an external signal. All of the event present signals are combined in a Logical OR function that is transmitted to the exterior by means of an open collector output with pull-up resistance. When an event is produced, the output takes the logic value '1' though the use of the mention pull-up resistance, whilst in the state of no events active, the circuit operates normally placing a logic value of '0' on the output. The open collector logic value '1' permits a bi-directional communication though the signal.

The method for both the freezing of the circuit and its reactivation consists, en first place, in the activation of a clock control signal over every sequential element of the design. This is achieved though the use of a signal "Clock Enable". When the circuits enters into the state of an event being detected, signalled to the exterior by a change of logical '0' to '1' on the output, the Clock Enable signal is deactivated (all clock sensitive logic disabled). When an exterior circuit forcing a transition from '1' to '0' on the open collector output, a detection circuit produces a single clock cycle pulse of the global Clock Enable signal. The use of an open collector output with pull-up permits the bidirectional communication of the signal and can be used as the clock control. In order to identify the condition that has triggered the event, the internal state can be read by normal means and this permits the reading of each and every event signal, and by this means identify which event has been produced.

The method permits the introduction in an almost limitless fashion the event conditions; they can be introduced in a form that is automatic and transparent to the user. The mentioned circuits are introduced in the high level language, and therefore the whole process is susceptible of being automated into the normal design flow. Given that the number of possible events is almost limitless, and only depends on the capacity of the emulator, the user can introduce as many events as desired though a simple high level description of each one, a program uses the description to perform the automated insertion of all the changes.

The use of this design flow in the traditional design of an integrated circuit consists in the use of an emulator with capacity to debug the design though the introduction of events and the inspection of the results. It enables the introduction of new debugging techniques though the use of the advanced capabilities of the emulators. Thanks to the insertion of events it is possible to carry out the verification of functionality in a way extraordinarily more powerful than the traditional methods of circuit verification. Therefore the insertion and use of the circuits described bring the possibility of internal analysis during circuit execution or to be precise, during the execution of a totally functional system.

### DESCRIPTION OF THE DRAWINGS

To complete the description, and with the object of aiding the understanding of the invention, there follows as an integrated part of this description various drawings, which illustrate without limitation the following:
Figure 1. - Shows the architecture of the necessary circuit to complete the requirements of the method of the invention, for several associates or independent events.
Figure 2. - Shows the circuit to control the clock of the system.
Figure 3. - Shows, a block diagram of the methodology to follow for development of digital integrated circuits.

### PREFERABLE REALIZATION OF THE INVENTION

The circuit object of the analysis, from now on the COA, consists of signals, combinational operations and sequential elements that work, in general, in parallel. The circuit for realising the test, from now on the CFT, contributes an essential part of the invention. It has the task of detecting determined situations, generally associated with the value of internal signals and possible combined with time dependencies during the functioning of the COA, and which result of special interest to the circuit designer/debugger. This is achieved though the selection and description of events. The events are situations of interest that are detected during the functioning of the circuit described by the user. In the case of the activation of an event during the normal functioning of the circuit it can react in two non exclusive ways:
- The sequential elements stop and maintain "frozen"
- It retains the state.

In both cases the designer can inspect the internal values of the system state and analyse the results.

Starting from the concept of an "event", the CFT should support the following tasks:
- It must watch over a determined combination of signals during execution, that is, is must signal when a determined event has been realised.
- It should track and control execution time, that is, it must signal when a time condition has been met.
- It must generate a signal or flag that records the event, whatever the cause of the event.
- It must be able to freeze the circuit in order to permit the analysis of the state in a graphical or similar system.
- It must communicate that the system has produced an event and the event must be identifiable.
- It must be able to resume normal execution.

In order to perform the tasks stated above, the CFT must include the following components.
- Comparators to watch over each programmed event.
- Timers the count clock cycles in order to match over time events.
- A circuit with the structure of a finite state machine for each programmed event for the identification of which event has been produced.
- A signal that disables the system clock and freezes the activity within the COA.
- An external control signal that is used to communicate when an event has been produced.
- An external signal for the reactivation of the COA and clearing the event flag produced.
- A way to execute single cycle execution.

The method proposed does not impose restrictions on the number of events or there form other that those derived from the chosen emulator for the physical realisation of the system.

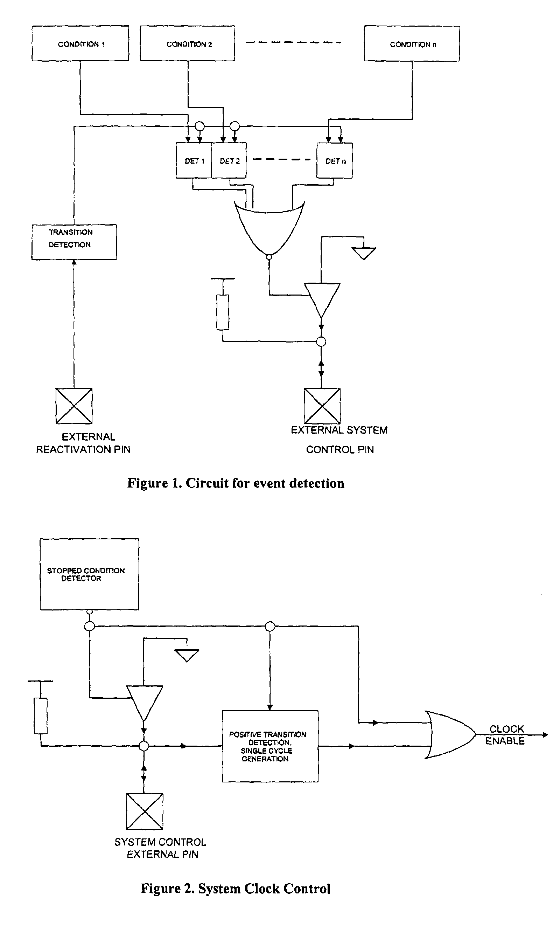

In accordance with the relationships described above, the architecture of the circuit is represented in Figure 1, (1), (1')...(1ⁿ) correspond to specific conditions or events, (2), (2')... (2ⁿ) correspond to their respective detectors. The reference (3) is a transition detector and the references (4) and (5) an external pad for reactivation and control of the system.

As can be observed in the Figure 1, the architecture does not present limitation in size or possibility of event observation. That is the CFT has a generic character, and the limitations are only the available resources of the emulator. The circuit is described in high level description language (HDL) and the configuration of each comparator from its parametric description.

The clock control circuit, shown in the Figure 2, contains the block (6) that detects the stopped condition, the external pad (5) mentioned earlier that controls the system, the block (7) that detect a positive transition, a generator of a pulses that produces the signal (8) that enables the system clock. Therefore the section of step-by-step execution is based on the use of the control signal, that given its character bi-directional permits the activation of the system clock during a single clock cycle. The central circuit consists of a state machine that can be activated by means of a transition in the system control signal.

The circuits described in the Figures 1 and 2 are complementary and they share the external circuitry.

In reference to the current methods of design of large digital circuits, as mentioned above, hardware description languages (HDLs) are used. Through the use of these languages the circuits are described with a certain level of abstraction, and though a process of synthesis and optimization the final circuits are generated. Thanks to these languages, the generation of digital circuits has greatly accelerated and permits the elaboration of highly parametric and generic circuits.

The CFT is connected in a natural way to the COA, given that both are described in a similar manner, which is though the use of a HDL. Once the synthesis of the union of both circuits has been realised, the result contains both the original design and the additional specific test circuit required for the analysis.

One of the possibilities of the method is that it is possible to define a simple language for the specification of the events that allows the automation and transparency of the system.

The analyses system uses the following elements:
- Circuit Emulator (CE), that emulates digital systems, for example one or more FPGAs that meet the requirements stated in the section antecedents of the invention. It must be capable of being reconfigured as many times as required, capable of having the internal state and configuration read, it must have the ability to freeze the clock in a controlled way and finally it must provide sufficient performance in order to emulate the COA in the conditions of the design.
- System of Visualisation (SV) that permits the representation of the system state to the user in a form that it can be understood. In general this element will consist of a software program running on a personal computer or workstation, and has the task of supervision and control of the emulation process.
- Link Circuits (LC) forming the bridge between the circuit emulator (CE) and the system of visualisation (SV). It is responsible for making the protocol conversions between the two systems and the transfer of information between them. Normally it would consist of an application specific integrated circuit, programmable or not.

The functionality of the system is the following. The CE is configured with both the COA and CFT circuits, it is inserted within the final system and communicates with the SV trough the LC when a event situation has been met. In the instance of an event, the circuit emulator:
- Stops evolving and enters a "frozen" state (Clock enable is deactivated).
- Maintains the system state in order to be analyzed.

The following step is the transfer of the contents of the circuit emulator to the system of visualization, where the event is identified, and the information is processed so that it can be presented in an understandable form.

Finally the continue order is sent from the SV to the CE, be it in the form of a single clock step or by the external reactivation signal.

From the methodological point of view the CFT facilitates in a natural way the mechanisms of stopping and continuing of the system and permits the introduction of control and trigger mechanisms that aid the detection and analysis of errors during the functioning of the system. The circuit can be introduced from a high level description (HDL) of the system, and therefore from a software tool in the first steps of the design flow. The description of the additional circuits can be determined from parameters, and therefore the realisation and insertion of the CFT can be performed in a completely automatic way.

The emulator devices mentioned above can be inspected and permits the reading of the physical registers and signals values within the emulator. This information can be back notated to the original HDL description using a map file produced by the synthesis process. The process of internal inspection also requires information about the structure of the internal state information. This information is provided by the component makers.

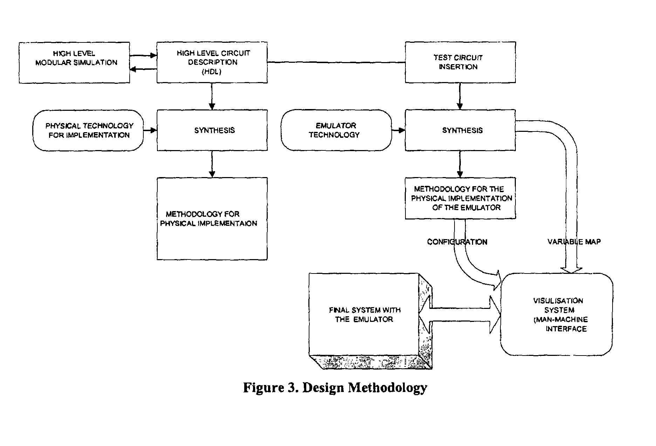

Figure 3 represents the design methodology in the form of a flow scheme. The block (9) corresponds to the modular high level simulation and verification, the block (10) to the high level (HDL) description, the block (11) to the physical implementation technology. The block (12) is the process of synthesis and the block (13) the method of physical realisation. In parallel, the block (14) corresponds to the insertion of the test circuitry, the block (15) to the emulator technology, the block (16) to the synthesis, the block (17) to the methodology for the physical implementation for the emulator, the block (18) is the system for visualisation (man-machine interface) and the block (19) the final emulator system. The arrows (20) and (21) represent the configuration and variable map.

Therefore, starting from the internal inspection of the emulator it is possible to relate the high level code with their actual values during real execution. The main consequent of this feature is that the system can be perfectly characterised before an event, and what adds great potential is the ability to identify which event from an unlimited number of possibilities.

## Claims

1. A method for the analysis and functional test of large digital circuits using hardware emulators. It is **characterised by** including a circuit that watches over combinational and time events together with their simultaneous combination. The user decides in every moment what signals should be monitored though the insertion of comparators to advise of the event, with the user of timers to control the activation of the event. The events can be deactivated from the user interface by the setting of an additional internal signal.

2. A method for the analysis and functional test of large digital circuits as stated in claim 1. The method for both the freezing of the circuit and its reactivation consists, in first place, of the activation of a control that disables the clock in every synchronous element in the circuit. This can be achieved by use of the "Clock Enable" signal, provided for this purpose. While the circuit is stopped due to the detection of an event, it is possible to generate a single clock cycle pulse in the clock enable signal, producing a single step in the synchronous state of the system. This is generated from the user interface by a circuit that detects transitions on a bidirectional output. The use of an open collector pull-up strategy allows a single pin to act as both a control of the clock and detector of the stopping event.

3. A method for the analysis and functional test of large digital circuits as stated above, **characterised by** the fact that for the identification of the event that produces the stopping of the system can be identified by the supported reading of the emulator configuration. As stated in the above claims, the reading of the system configuration allows the identification of each and every event register together with its value, and therefore the identification of which register has produced the event.

4. A method for the analysis and functional test of large digital circuits as stated above, **characterised by** the condition of events, unlimited in their number. They are introduced in the design in a way completely automatic and transparent to the user at the high level design stage. The events are introduced by the use of a simple functional description given by the user, while a program permits the automatic creation of the necessary design changes.

5. A method for the analysis and functional test of large digital circuits as stated above, **characterised by** the existence of: Comparators to watch over each event, together with timers that count clock cycles and watch over time dependant events. A finite state machine type circuit registers the state of each event, and permit the identification of an event once it has been detected. An internal signal for the deactivation of the system clock and the freezing of the COA once an event has been produced. An external signal to communicate the situation of "event produced" and the cycle-by-cycle execution of the design. An external signal to force the reactivation of the system and the clearing of an event that had produced the freezing.
